# EUROPÄISCHE PATENTANMELDUNG

(11) **EP 4 064 418 A2**
(43) Veröffentlichungstag der Anmeldung: **28.09.2022**
(21) Anmeldenummer: 22162421.6
(22) Anmeldetag: 16.03.2022
(51) Int. Cl.: H01M 10/48, G01R 31/392

(54) **BATTERIEMODUL**

(30) Priorität: 22.03.2021 DE 102021107009
(71) Anmelder: VOLKSWAGEN AG, 38440 Wolfsburg (DE)
(72) Erfinder: MAISCHIK, Thomas, 38173 Sickte (DE); HENNIG, Jakob, 38124 Braunschweig (DE)
(74) Vertreter: Beck & Rössig European Patent Attorneys

(57) **Zusammenfassung**

Ein Batteriemodul (1) umfasst ein Gehäuse (2) und eine Vielzahl von Batteriezellen (3), die in dem Gehäuse (2) angeordnet sind. Ein flüssiges Medium (4) ist in dem Gehäuse (2) die Batteriezellen (3) umgebend angeordnet, um die Batteriezellen (3) innerhalb des Gehäuses (2) mit einem hydrostatischen Druck zu beaufschlagen. Weiterhin sind eine Druckerzeugungsvorrichtung (5) zur Einstellung des Drucks des flüssigen Mediums (4), und eine Steuereinrichtung (8) zur Ansteuerung der Druckerzeugungsvorrichtung (5) vorgesehen, wobei die Steuereinrichtung (8) derart konfiguriert ist, um eine Prüfroutine zur Alterungsbestimmung durchzuführen, bei welcher mittels der Druckerzeugungsvorrichtung (5) ein Druckpuls erzeugt wird und die hieraus resultierende Druck- und Volumenänderung des hydrostatischen Systems aus Batteriezellen (3) und flüssigem Medium (4) zu einer Referenzkennlinie in Beziehung gesetzt werden. In einer Variante sind eine Druckmesseinrichtung (7) zur Erfassung des Drucks des flüssigen Mediums (4) und eine Steuereinrichtung (8) vorgesehen, wobei die Steuereinrichtung (5) derart konfiguriert ist, um bei Feststellen des Überschreitens eines Schwellwerts für den Gradienten des Drucks des flüssigen Mediums (4) ein Warnsignal zu generieren. Beide Varianten sind auch kombinierbar.

## Beschreibung

Die Erfindung bezieht sich auf ein Batteriemodul umfassend ein Gehäuse und eine Vielzahl von Batteriezellen, die in dem Gehäuse angeordnet sind, ein flüssiges Medium, das in dem Gehäuse die Batteriezellen umgebend angeordnet ist, um die Batteriezellen innerhalb des Gehäuses mit einem hydrostatischen Druck zu beaufschlagen, und eine Druckerzeugungsvorrichtung zur Einstellung des Drucks des flüssigen Mediums.

Ein derartiges Batteriemodul ist aus DE 10 2018 123 682 bekannt.

Die Batteriezellen von Hochvolt-Batteriemodulen, wie sie beispielsweise als Traktionsbatterien in Fahrzeugen oder als Pufferspeicher zur Anwendung kommen, unterliegen im Betrieb einer Volumenänderung, dem sogenannten "Breathing". Eine solche Volumenänderung tritt während Lade- und Entladevorgängen des Batteriemoduls durch Lithium-Ein-/Auslagerung in den Anoden- und Kathodenmaterialien (Lithiierung/Delithiierung) aufgrund von Umgitterungsvorgängen auf. Dieses Breathing der Batteriezellen kann, je nach Zellchemie, unterschiedlich stark ausgeprägt sein. In einem hydrostatisch verspannten Batteriemodul verändert sich hierdurch in Abhängigkeit des Ladezustands das Volumen des hydrostatischen Systems, d.h. das druckbeaufschlagte Gesamtvolumen aus Batteriezellen und flüssigem Medium.

Ferner unterliegen Batteriezellen während ihres Betriebs unterschiedlichen Alterungsvorgängen. Diese Alterungsvorgänge führen langfristig zu einer Abnahme der nutzbaren Kapazität sowie zu einer Erhöhung des Innenwiderstandes des Batteriemoduls. Beides kann elektrisch gemessen und zur Beurteilung des Alterungszustand herangezogen werden.

Bei Alterungsvorgängen kommt es ebenfalls zu einer Volumenänderung der Batteriezellen, welche in Abgrenzung zum oben erläuterten Breathing als "Swelling" bezeichnet wird, da sich die Batteriezellen bleibend etwas aufblähen. Ursache hierfür ist die Freisetzung von Gasen in den Batteriezellen infolge von chemischen Reaktionen bei der Alterung.

Beide Effekte Breathing und Swelling überlagern sich, so dass die Unterscheidung der Ursachen für eine Volumenzunahme der Batteriezellen auf den ersten Blick schwierig ist.

Vor allen bei Batteriezellen im "Pouch-Format", welche eine flexible Folie als Hülle aufweisen, macht sich ein Aufblähen besonders deutlich bemerkbar. Eine Volumenzunahme ist jedoch auch bei Rundzellen und prismatischen Zellen zu beobachten, bei denen die metallische Hülle zwar stabiler ist, jedoch wie eine Folie ebenfalls eine gewisse Elastizität aufweist. Eine Aufwölbung durch Alterungsphänomene ist hier ebenso wie bei Batteriezellen im "Pouch"-Format möglich.

Das Swelling von Batteriezellen führt nicht nur zu einer Abnahme der Leistungsfähigkeit, sondern kann ebenso Sicherheitsrisiken mit sich bringen, da gealterte Zellen unter Umständen öffnen oder einen Thermal Runanway verursachen können. Unter einem "Thermal Runaway" versteht der Fachmann ein thermisches Durchgehen im Sinne einer Überhitzung einer Batteriezelle aufgrund eines sich selbst verstärkenden Wärme produzierenden Prozesses. Ein solches Durchgehen kann im ungünstigsten Fall ein Bersten der betreffenden Batteriezelle bedeuten, welches auf benachbarte Batteriezellen übergreifen kann. Eine zuverlässige Detektion des Alterungs- und Sicherheitszustandes ist deswegen besonders wichtig.

Wie bereits eingangs erwähnt, betrifft die vorliegend Erfindung Batteriemodule, bei welchen die Batteriezellen abhängig von der jeweiligen Zellchemie hydrostatisch verspannt sind. Dazu wird ein externer Druck auf die einzelnen Batteriezellen aufgebracht, damit diese optimal funktionieren. Ein entsprechendes Verspannsystem mit einer Druckerzeugungsvorrichtung ist in der Lage, trotz einer Volumenänderung durch Breathing und/oder Swelling den benötigten Verspanndruck entweder passiv aufzuprägen oder aktiv einzuregeln.

Wie in DE 10 2018 123 682 A1 offenbart, beruhen herkömmliche Methoden zur Beurteilung des Alterungszustands auf der Erfassung batterieelektrischer Größen wie Strom, Spannung, Innenwiderstand und Kapazität und zur Beurteilung des Sicherheitszustands auf der Erfassung der Temperatur und der vorgenannten batterieelektrischen Größen. In Abhängigkeit dieser Größen wird in DE 10 2018 123 682 A1 der Druck im Batteriemodul eingestellt.

Die batterieelektrischen Größen werden dabei für die einzelnen Batteriezellen ermittelt. Entsprechende Sensorleitungen müssen folglich über die gesamte Lebensdauer intakt bleiben. Hier ergeben sich bei Ausfall von Sensorleitungen Redundanzprobleme.

Überdies sind Temperaturmessungen in der Regel nur lokal möglich und zudem unter Umständen recht träge.

DE 10 2015 016 361 A1 beschreibt verschiedene Strategien zur Bestimmung des Alterungszustands. Die Idee einer Prüfroutine mit Druckpuls und Auswertung der Impulsantwort wird jedoch genauso wie in DE 10 2018 123 682 A1 nicht gelehrt.

Die vorliegende Erfindung zielt darauf ab, den Alterungs- und Sicherheitszustand von Batteriezellen in einem Batteriemodul bei hydrostatischer Verspannung genauer und zuverlässiger zu bestimmen.

Diese Aufgabe wird durch ein Batteriemodul mit den Merkmalen von Patentanspruch 1 gelöst. Dieses zeichnet sich insbesondere dadurch aus, dass eine Druckerzeugungsvorrichtung zur Einstellung des Drucks des flüssigen Mediums und eine Steuereinrichtung zur Ansteuerung dieser Druckerzeugungsvorrichtung vorgesehen sind, wobei die Druckerzeugungsvorrichtung derart konfiguriert ist, um eine Prüfroutine zur Alterungsbestimmung durchzuführen, bei welcher mittels der Druckerzeugungsvorrichtung ein Druckpuls erzeugt und die hieraus resultierende Druck- und Volumenänderung des hydrostatischen Systems aus Batteriezellen und flüssigem Medium zu einer Referenzkennlinie in Beziehung gesetzt werden.

Aus der Reaktion auf den Druckpuls kann geschlossen werden, in welchem Umfang Breathing und Swelling summarisch über alle Zellen im Batteriemodul aufgetreten sind. Hierdurch können unabhängig von batterieelektrischen Größen oder aktuellen Temperaturen wertvolle Informationen über den Alterungs- und Sicherheitszustand gewonnen werden.

Diese Informationen können für sich Grundlage für die Bestimmung des Alterungszustands sein oder aber mit den oben erläuterten Maßnahmen kombiniert werden. Hierdurch wird letztlich die Batteriesicherheit erhöht.

Die Erfindung lässt sich an einem hydrostatischen Verspannsystem mit geringem Zusatzaufwand implementieren, da keine zusätzlichen Bauteile erforderlich werden.

Besondere Ausführungsarten der Erfindung sind Gegenstand weiterer Patentansprüche.

So kann die Druckerzeugungsvorrichtung einen Druckkolben umfassen, wobei ferner eine Messeinrichtung zur Erfassung der Kolbenstellung vorgesehen ist, deren Signal zur Bestimmung der Volumenänderung herangezogen wird. Auf diese Art und Weise lässt sich mit geringem Aufwand eine Information über die Volumenänderung des hydrostatischen Systems erhalten.

Die Referenzkennline kann für ein Batteriemodul vorab bestimmt und beispielsweise in der Steuereinrichtung abgelegt sein. In einer Ausführungsart bildet diese Referenzkennline die Abhängigkeit des Drucks von einer das Volumen des hydrostatischen Systems repräsentierenden Größe im ungealterten Zustand des Batteriemoduls ab. Eine solche Referenzkennlinie kann beispielsweise durch Anwenden der Prüfroutine auf das Batteriemodul im ungealterten Zustand für jedes Batteriemodul individuell erzeugt und in der Steuereinrichtung abgelegt werden.

Gegebenenfalls können für verschiedene Ladezustände unterschiedliche Referenzkennlinien vorgehalten werden. Der Abgleich erfolgt dann in Abhängigkeit des aktuellen Ladezustands mit der entsprechenden Referenzkennlinie.

Gemäß einer weiteren Ausführungsart kann aus der Differenz des Druckanstiegs für eine vorgegebene Volumenänderung durch den Druckpuls im Vergleich zur Referenzkennlinie auf den Alterungszustand des Batteriemoduls geschlossen werden. Entsprechende Vergleichsparameter können beispielsweise in der Steuervorrichtung vorgehalten sein.

Gemäß einer weiteren Ausführungsart kann ferner aus der resultierenden Druck- und Volumenänderung infolge des Druckpulses auf das Ausmaß eines kompressiblen Gasvolumens in den Batteriezellen geschlossen wird. Je kleiner die Druckzunahme bei einer bestimmten Volumenverringerung durch einen Druckpuls ist, desto kompressibler ist das hydrostatische System. Solche Kompressiblitäten resultieren praktisch allein aus der Gasbildung in den Batteriezellen durch Swelling. Durch Breathing verursachte Volumenänderungen erhöhen die Kompressibilität nicht signifikant. Dies wird vorliegend dazu genutzt, das durch Alterung entstandene Gasvolumen zu bestimmen und anhand dessen Rückschlüsse auf den Alterungszustand zu ziehen.

Die Genauigkeit der Bestimmung des Alterungszustands auf der Grundlage von Swelling kann weiter erhöht werden, wenn die Volumenänderung zwischen geladenem und entladenem Zustand des Batteriemoduls, d.h. durch Breathing, im ungealterten Zustand als Referenz bei der Bestimmung des Ausmaßes des kompressiblen Gasvolumens in den Batteriezellen verwendet wird. In Abhängigkeit des Ladezustands kann hierdurch bestimmt werden, welcher Anteil einer Volumenänderung durch Breathing und welcher Anteil durch Swelling verursacht wird.

Eine den Druck repräsentierende Größe kann beispielsweise aus Ansteuerungsparametern der Druckerzeugungsvorrichtung gewonnen werden. Gemäß einer besonderen Ausführungsart ist vorzugsweise jedoch eine dezidierte Druckmesseinrichtung zur Erfassung des Drucks des flüssigen Mediums vorgesehen, die ein sehr genaues Signal zur Bestimmung der Druckänderung liefert, welches überdies für weitere Zwecke wie beispielweise eine Drucküberwachung und/oder Druckgradientenüberwachung unabhängig von der Druckerzeugungsvorrichtung herangezogen werden.

Die oben genannte Aufgabe wird weiterhin durch ein Batteriemodul gemäß Patentanspruch 8 gelöst. Dieses zeichnet sich insbesondere dadurch aus, dass eine Druckmesseinrichtung zur Erfassung des Drucks des flüssigen Mediums und eine Steuereinrichtung vorgesehen sind, wobei letztere mit der Druckmesseinrichtung zusammenwirkt und derart konfiguriert ist, um bei Feststellen des Überschreitens eines Schwellwerts für den Gradienten des Drucks des flüssigen Mediums ein Warnsignal zu generieren.

Ein hoher Druckgradient deutet auf ein starkes Aufblähen einer oder mehrerer Batteriezellen hin, welches für einen bevorstehenden Thermal Runaway charakteristisch ist. Dies kann zur Früherkennung genutzt werden, um die Detektion sicherheitskritischer Zustände zu verbessern. Insbesondere kann ein Thermal Runaway detektiert werden, bevor eine Batteriezelle öffnet und Gas abbläst ("Venting"). Somit kann eine erhöhte Redundanz bei der Früherkennung eines Therman Runaway (z.B. in Kombination mit einem Spannungssignal) erreicht werden. Im Vergleich hierzu würde ein Thermal Runaway mittels herkömmlicherTemperaturmessung aufgrund der thermischen Trägheiten und der im ungünstigsten Fall großen räumliche Entfernung der durchgehenden Batteriezelle von der Temperaturmessstelle deutlich später detektiert werden.

Das Überwachen auf das Überschreitens eines Schwellwerts für den Gradienten des Drucks des flüssigen Mediums kann ohne großen Mehraufwand mit den oben erläuterten Maßnahmen im Rahmen eines erweiterten Batteriesicherheitskonzepts kombiniert werden.

Die Kombination einer hydrostatischer Verspannung mit einem Batteriesicherheitskonzept auf Grundlage einer Alterungsbestimmung von Batteriezellen bis hin zur Möglichkeit der Früherkennung eines Thermal Runaway gestattet im Endeffekt die Einstellung eines optimalen Verspanndrucks in Abhängigkeit des Ladezustands (SoC), des Alterungszustands (SoH) sowie des Betriebszustands (Laden/Entladen) der Batteriezellen. Der diesbezügliche apparative Mehraufwand bleibt gleichwohl außerordentlich gering.

Insbesondere ist es möglich, die vorstehenden Maßnahmen in ein Batteriemodul gemäß DE 10 2018 123 682 A2 zu implementieren und die in dort offenbarten Maßnahmen zur Ansteuerung der Druckerzeugungsvorrichtung und zum Batteriemanagement um die vorstehend erläuterten Maßnahmen entsprechend zu ergänzen. Der diesbezügliche Offenbarungsgehalt aus DE 10 2018 123 682 A2 wird dementsprechend ausdrücklich in die vorliegende Offenbarung miteinbezogen.

Nachfolgend wird die Erfindung anhand eines in der Zeichnung dargestellten Ausführungsbeispiels näher erläutert. Die Zeichnung zeigt in:
- Fig. 1: eine schematische Darstellung eines Ausführungsbeispiels eines erfindungsgemäßen Batteriemoduls,
- Fig. 2: das Batteriemodul aus Fig. 1 mit Regelung des hydrostatischen Verspanndrucks bei einer Lithiierung/Delithiierung der Batteriezellen,
- Fig. 3: das Batteriemodul aus Fig. 1 bei einem Druckpuls zur Alterungsdetektion,
- Fig. 4: das Batteriemodul aus Fig. 1 mit einem beginnenden Thermal Runaway einer Batteriezelle,
- Fig. 5: ein Diagramm zur Veranschaulichung der Auswirkung eines Druckpulses, und in
- Fig. 6: ein Diagramm zur Veranschaulichung des Druckverlaufs und des Druckgradientenverlaufs bei einem Thermal Runaway.

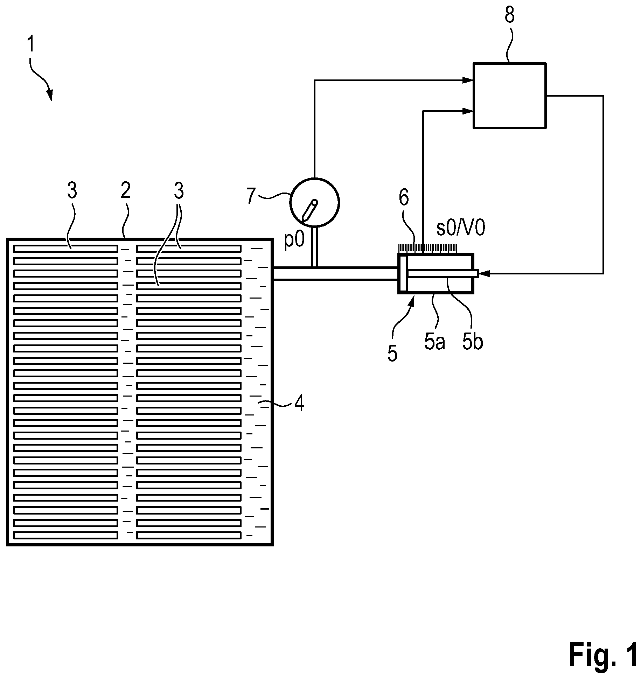

Das Ausführungsbeispiel in den Fig. 1 bis 4 zeigt ein Batteriemodul 1 am Beispiel eines Hochvolt-Batteriemoduls. Das Batteriemodul 1 kann beispielsweise als Traktionsbatterie in Kraftfahrzeugen, insbesondere in Personenkraftfahrzeugen und Nutzfahrzeugen, sowie in anderen Fahrzeugen zum Einsatz kommen. Weiterhin ist eine Verwendung als stationärer elektrischer Pufferspeicher möglich.

Das Batteriemodul 1 umfasst ein Gehäuse 2, in dem eine Vielzahl von Batteriezellen 3 angeordnet sind.

Die Batteriezellen 3 können Lithiumionenzellen sein, jedoch auch einen anderen Zelltyp aufweisen. Insbesondere können die Batteriezellen 3 sowohl solche mit flüssigem Elektrolyt als auch Feststoffzellen sein.

Die Batteriezellen 3 sind elektrisch kontaktiert und die Kontaktierung ist durch das Gehäuse 1 hindurch nach außen geführt.

Die Batteriezellen 3 können beispielsweise "Pouch-Format" ausgeführt sein, welche eine flexible Folie als Hülle aufweisen. Bei solchen Batteriezellen 3 macht sich ein alterungsbedingtes "Aufblähen" (Swelling) besonders stark bemerkbar, welches im ungünstigsten Fall in einem Öffnen oder Bersten der Batteriezelle 3 resultiert. Jedoch können die Batteriezellen 3 auch als Rundbatteriezellen, prismatische Batteriezellen oder in sonstige Weise ausgebildet sein, bei denen eine zumeist metallische Hülle zwar stabiler ist, welche jedoch beim Überschreiten eines gewissen Innendrucks der Batteriezelle 3 ebenfalls öffnen können.

In dem Gehäuse 1 ist ein flüssiges Medium 4 angeordnet, welches die einzelnen Batteriezellen 3 umgibt. Das flüssige Medium 4 kann beispielsweise eine Wärmeträgerflüssigkeit sein, welche dazu eingesetzt werden kann, die einzelnen Batteriezellen 3 zu kühlen. In einfachsten Fall leitet das flüssige Medium 4 Wärme aus den Batteriezellen 3 passiv nach außen über das Gehäuse 1 ab. Gegebenenfalls kann auch eine aktive Kühlung durch Umwälzung des flüssigen Mediums 4 innerhalb des Gehäuses 2 erfolgen.

Das flüssige Medium 4 ist mit einem Druck beaufschlagt, welcher größer als Atmosphärendruck ist. Dadurch wird auf die einzelnen Batteriezellen 3 jeweils ein hydrostatischer Druck ausgeübt. Das Gehäuse 1 ist entsprechend als Druckbehälter ausgeführt.

An dem Batteriemodul 1 ist eine Druckerzeugungsvorrichtung 5 zur Einstellung, insbesondere Regelung, des Drucks des flüssigen Mediums 4 vorgesehen. Mit dieser Druckerzeugungsvorrichtung 5 kann der hydrostatische Druck auf die Batteriezellen 3 auf einem gewünschten Niveau gehalten und bei Bedarf erhöht oder verringert werden.

Die Batteriezellen 3 und das flüssigen Medium 4 werden nachfolgend gemeinsam auch als hydrostatisches System bezeichnet, welches ein mit dem durch die Druckerzeugungsvorrichtung 5 erzeugten Druck beaufschlagtes Volumen aufweist, das sich in insbesondere in Abhängigkeit von Breathing und Swelling der Batteriezellen 3 bei ansonsten konstant gehaltenem Druck ändern kann. Im Betrieb kann der Druck mit den in DE 10 2018 123 682 A2 beschriebenen Methoden eingeregelt werden.

In einer Ausführungsvariante kann die Druckerzeugungsvorrichtung 5 einen Druckzylinder 5a mit einem Druckkolben 5b umfassen, wie dies in den Fig. 1 bis 4 dargestellt ist. Aus der Stellung des Druckkolbens 5b und dem Querschnitt des Druckzylinders 5a kann bei einer Verlagerung des Druckkolbens 5b um einen Weg s die Veränderung des Volumens des hydrostatischen Systems ermittelt werden.

In einer Ausführungsvariante ist ferner eine Messeinrichtung 6 zur Erfassung der Kolbenstellung des Druckkolbens 5b vorgesehen. Deren Signal wird zur Bestimmung der Volumenänderung herangezogen, wie dies vorstehend erläutert wurde. Es ist jedoch möglich, eine Veränderung des Volumens des hydrostatischen Systems auch auf andere Art und Weise zu gewinnen.

Ferner kann das Batteriemodul 1 eine Druckmesseinrichtung 7 zur Erfassung des Drucks des flüssigen Mediums 4 aufweisen. Diese Druckmesseinrichtung 7 kann gegebenenfalls Teil der besagten Druckerzeugungsvorrichtung 5 sein oder aber auch eine separate Einheit oder zusätzlich zur Druckerzeugungsvorrichtung 5 vorhanden sein. Der Druck des flüssigen Mediums 4 kann gegebenenfalls jedoch auch aus Parametern zur Ansteuerung der Druckerzeugungsvorrichtung 5 abgeleitet werden, so dass eine dezidierte Druckmesseinrichtung 7 auch entfallen kann.

Die Aktuatorik und Sensorik kann insbesondere auch wie in DE 10 2018 123 682 A2 näher beschrieben ausgeführt sein.

Das Ausführungsbeispiel zeigt weiterhin eine Steuereinrichtung 8 zur Ansteuerung der Druckerzeugungsvorrichtung 5. Die Steuereinrichtung 8 ist derart konfiguriert, um eine Prüfroutine zur Alterungsbestimmung durchzuführen. Entsprechende Algorithmen sind in der Steuereinrichtung 8 abgelegt.

Die Prüfroutine beinhaltet die Erzeugung eines Druckpulses durch entsprechende Betätigung der Druckerzeugungsvorrichtung 5. Dieser Druckpuls besteht in einer kurzzeitigen vorzugsweise geringfügigen Be- oder Entlastung des hydrostatischen Systems aus Batteriezellen 3 und flüssigem Medium 4. Die Dauer eines solchen Druckpulses liegt vorzugsweise im Bereich von 0,01 bis 5 s. Je nach Übersetzung der Druckerzeugungsvorrichtung 5, beispielsweise eines Kolbens derselben, sind jedoch auch extrem lange Druckpulse von 30s bis 60s möglich. Die Be- oder Entlastung liegt vorzugsweise im Bereich von vorzugsweise maximal +/- 30%, alternativ auch +/- 10 %, +/- 50 % oder +/- 100 % (je nach gewähltem Absolutdruck) des normalen Verspanndrucks des Batteriemoduls 1.

Für die Ausübung eines Druckpulses kann beispielsweise der Druckkolben 5b um einen bestimmten Weg Δs verlagert werden. Je nach Richtung erhöht oder verringert sich hierdurch der Druck des hydrostatischen Systems.

Diese Veränderung wird zur Bestimmung des Alterungszustands der Batteriezellen 3 herangezogen, wie dies nachfolgend näher erläutert werden soll.

Dazu wird die aus dem Druckpuls resultierende Druck- und Volumenänderung des hydrostatischen Systems zu einer Referenzkennlinie in Beziehung gesetzt.

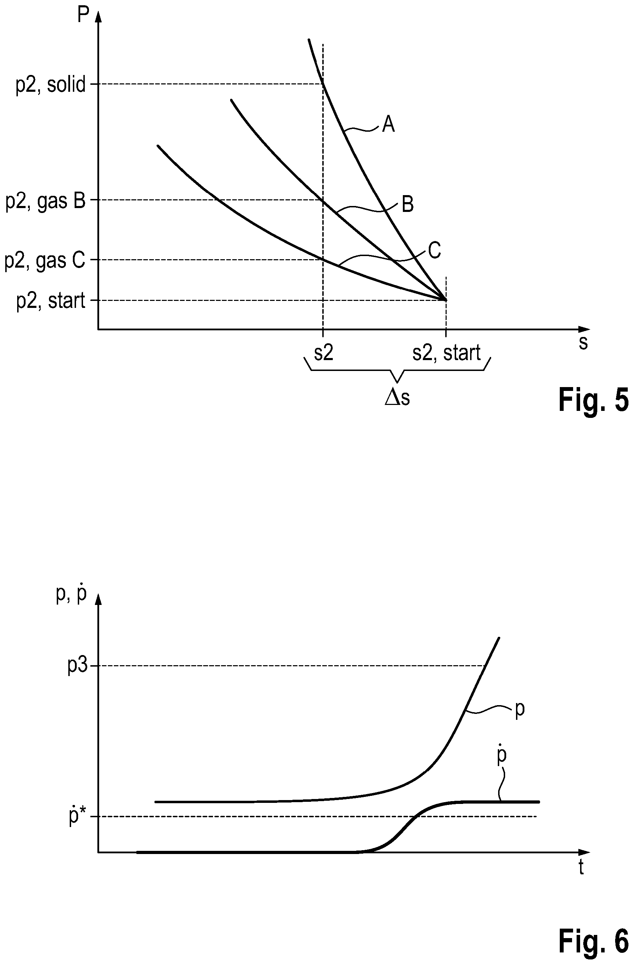

Die Referenzkennline kann für ein Batteriemodul 1 vorab bestimmt und beispielsweise in der Steuereinrichtung 8 abgelegt sein. Bei Verwendung der in den Figuren dargestellten Druckerzeugungsvorrichtung 5 mit einem Druckzylinder 5a und Druckkolben 5b kann das Volumen V auf eine Weggröße s des Druckkolbens 5b reduziert werden, d.h. der Druck des flüssigen Mediums 4 in Abhängigkeit des Kolbenwegs s dargestellt werden, wie dies in Fig. 5 gezeigt ist. Es ist jedoch zu betonen, dass die Reduzierung auf eine Weggröße lediglich eine mögliche Ausführungsform ist und eine Volumenveränderungen auch auf andere Art und Weise erfasst werden kann.

In Fig. 5 sei lediglich beispielhaft angenommen, dass sich das Batteriemodul 1 vor einem Druckpuls in einen Zustand mit einem Druck p₂,start und einem Kolbenweg s₂,start (oder einem entsprechenden Volumen) befindet. In dieser Situation wird vorliegend mit der Druckerzeugungsvorrichtung 5 eine Druckerhöhung vorgenommen, derart, dass der Druckkolben um den Weg Δs verschoben wird. In Fig. 5 wird folglich der Kolbenweg von s₂,start auf s₂ verringert, so dass das Volumen des hydrostatischen Systems reduziert wird. Dabei steigt der Druck mehr oder weniger stark an. Kennlinie A zeigt ein Batteriemodul 1 im ungealterten Zustand. Hier tritt an den Batteriezellen3 lediglich Breating auf, d.h. das Volumen verändert sich lediglich geringfügig mit dem Ladungszustand (SoC). Das gesamte hydrostatische System bleibt relativ steif. Dementsprechend fällt die Druckzunahme vom Ausgangsdruck p₂,start auf p₂,solid sehr groß aus.

In einer Ausführungsvariante kann die Kennlinie A als Referenzkennlinie für die Alterungsbestimmung herangezogen werden. Diese kann für jedes Batteriemodul 1 im ungealterten Zustand mittels der Prüfroutine anfänglich erzeugt und in der Steuereinrichtung 8 abgelegt werden. Entsprechende Kennlinien A können gegebenenfalls für verschiedene Ladungszustände eines ungealterten Batteriemoduls als Referenzkennlinien generiert werden.

Alternativ kann eine Referenzkennlinie, gegebenenfalls auch unter Berücksichtigung weiterer Einflüsse, für einen Batteriemodultyp beispielsweise experimentell ermittelt und vorab im der Steuereinrichtung 8 abgelegt werden.

Mit zunehmender Gasbildung in den Batteriezellen 3 aufgrund von Alterungsprozessen nimmt die Kompressibilität des hydrostatischen Systems zu. Kennlinie B zeigt einen ersten Alterungszustand. Bei diesem steigt der Druck bei einen Kolbenweg Δs weniger stark auf den Druck p₂,gasB an. Die Differenz zu p₂,solid kann vorliegend als ein Maß für den Alterungszustand des Batteriemoduls 1 gewertet werden.

Bei noch stärkerem Swelling fällt der Druckanstieg entsprechend schwächer aus, wie Kennlinie C in Fig. 5 veranschaulicht. Hier steigt der Druck nur noch auf p₂,gasC an. Die im Vergleich zu den Kennlinien A und B weiter erhöhte Kompressibilität lässt auf eine vermehrte Gasbildung in den Batteriezellen 3 und damit auf einen fortgeschrittenen Alterungszustand schließen.

Vorliegend kann beispielsweise das Erreichen einer Grenzkennlinie wie der Kennlinie C als Hinweis gewertet werden, das betreffende Batteriemodul 1 außer Betrieb zu setzten.

Fig. 5 dient lediglich zur Veranschaulichung des Prinzips der Erfindung. Anhand der Kennlinien A bis C ist für den Fachmann ohne Weiteres klar, dass ein Druckpuls beispielsweise nicht immer mit einer vorbestimmten Wegvorgabe Δs erfolgen muss. Aus der Kenntnis der Referenzkennlinie kann jedes sich aus einem Druckpuls resultierende Wertepaar aus resultierender Druck- und Volumengröße zur Bestimmung des Alterungszustand verwendet werden.

Zur Verbesserung der Genauigkeit kann der Einfluss des Breathings aus der Referenzkennlinie herausgerechnet werden, indem bei der Prüfroutine der Ladungszustand (SoC) des Batteriemoduls 1 zusätzlich berücksichtigt wird.

Fig. 1 zeigt ein erfindungsgemäßes Batteriemodul 1 im Neuzustand. Die Batteriezellen 3 im Batteriemodul 1 sind hierbei mittels der Druckerzeugungsvorrichtung 5 zur Einstellung des Drucks des flüssigen Mediums 4 mit Druck beaufschlagt, d.h. hydrostatisch jeweils vorgespannt.

In diesem Ausgangszustand mit ungealterten Batteriezellen 3 wird ein Verspanndruck p0 vorgegeben. Dabei wird der Druckkolben 5b bei einer Position s0 eingeregelt. Dadurch kann das Volumen des gesamten hydrostatischen Systems im Ausgangszustand ermittelt werden oder auch lediglich der Batteriezellen 3, wenn man annimmt, dass das flüssige Medium 4 inkompressibel ist. Dieser Zustand wird als Referenz gespeichert. Allein aus dem Initialzustand mit der Position s0 kann allerdings noch nicht auf ein Volumen V0 geschlossen werden. Erst durch Alterung der Batteriezellen 3 erhöht sich das Volumen der Batteriezellen 3 im System, wodurch sich eine andere Druckkolbenposition ergibt. Aus der Differenz der Druckkolbenpositionen kann die Volumenänderung innerhalb der Batteriezellen geschlussfolgert werden.

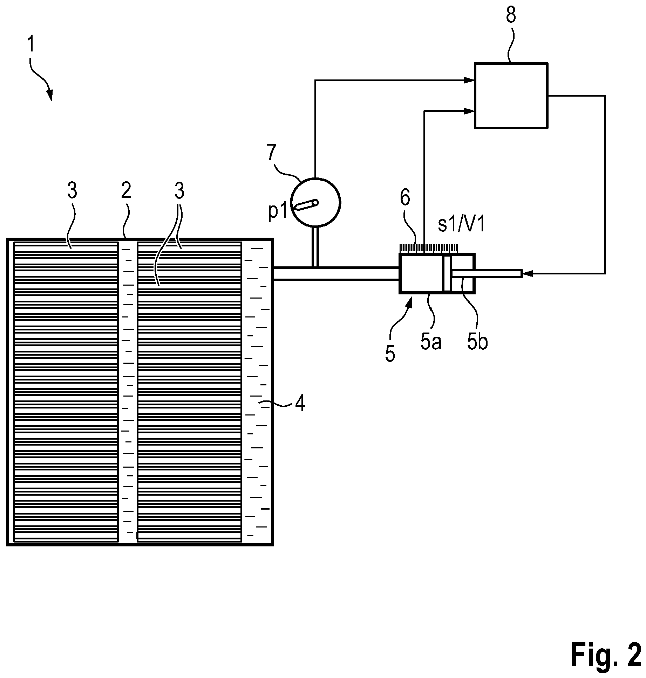

Mit zunehmender Betriebsdauer im Ausgangszustand kann an den Batteriezellen 3 eine gewisse Volumenzunahme in Form von Breathing beobachtet werden. Wie in Fig. 2 veranschaulicht, verändert sich infolge von Lithiierung und Delithiierung der Batteriezellen 3 das Zellvolumen. Dies hängt unter anderem vom verwendeten Zelltyp ab und kann von Batteriezelle zu Batteriezelle 3 variieren. Über die Druckerzeugungsvorrichtung 5 kann der Systemdruck p1 des flüssigen Mediums 4 und damit der Verspanndruck auf die Batteriezellen 3 dynamisch angepasst werden.

Durch Nachführung des Druckkolbens 5b auf den entsprechenden Verspanndruck p1 kann die Volumenänderung der Batteriezellen 3 durch Breathing im normalen Betrieb ermittelt werden. Zugleich ist eine optimale Verspannung der Batteriezellen gewährleistet.

Über ein Sollwertmodell, welches beispielsweise im Steuergerät 8 abgelegt ist, kann der jeweils gewünschte Verspanndruck vorgegeben und über die Druckerzeugungsvorrichtung 5 eingeregelt werden. Das Sollwertmodel kann hierbei außerdem den Ist-Druck des flüssigen Mediums 4 sowie folgende Parameter als Eingangsgrößen - einzeln oder in Kombination oder Unterkombination - heranziehen, nämlich den Ladezustand (SoC), den Alterungsgrad (SoH), die Temperatur und den aktuellen Betriebszustand (Laden/Entladen).

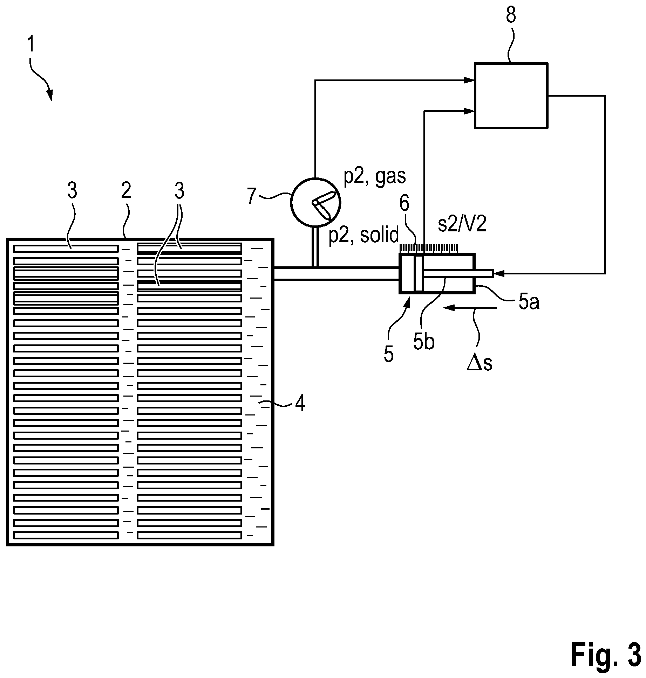

Fig. 3 zeigt, wie bei einem Batteriemodul 1 der oben erläuterten Art der Alterungszustand bestimmt werden kann. Batteriezellen 3, bei welchen die Volumenzunahme durch Lithiierung (Breathing) entstanden ist, lassen sich praktisch nicht komprimieren. Dagegen sind Batteriezellen 3 mit einer Volumenzunahme durch Gasbildung (Swelling), welche als Alterung verstanden wird, komprimierbar.

Durch einen Druckpuls, der über die Druckerzeugungsvorrichtung 5 als Prüfsignal aufgebracht werden, wird das entstandene Gas komprimiert. Es stellt sich am flüssigen Medium 4 dann ein Druck p2,gas (Kennlinie B oder C in Fig. 5) ein. Falls kein Gas entstanden ist, ist das gesamte hydrostatische System nahezu inkompressibel und die Reaktion auf den Druckimpuls ist ein Druck p2,solid (Kennlinie A in Fig. 5). Ist also Gas entstanden, wird der Druckanstieg als Reaktion auf einen Druckpuls geringer ausfallen als wenn noch kein Gas entstanden ist. Es gilt folglich p2,gasB,C < p2,solid. Anhand der Reaktion auf den Druckpuls kann somit auf den Alterungszustand des Batteriemoduls 3 geschlossen werden.

Eine Batteriezelle 3 wird durch Swelling zunehmend kompressibler bzw. verliert an Steifigkeit. Bei Vorgabe der Bewegung des Druckkolbens 5b während des Druckpulses stellt sich durch die erhöhte Kompressibilität des gesamten hydrostatischen Systems ein Druck p2,gasB,C<p2,solid ein. Durch Abgleich der Parameter und Vergleich mit den Daten im Ausgangszustand gemäß Fig. 1 ist eine erste Bewertung des Alterungszustandes des Batteriemoduls 1 möglich.

Weiterhin ist es auf diese Art und Weise auch möglich, das gesamte kompressible Volumen, welches praktisch dem Gasvolumen in den Batteriezellen 3 entspricht, im hydrostatischen System zu bestimmen und daraus Rückschlüsse auf den genauen Alterungszustand aller Batteriezellen 3 zu gewinnen.

Dabei kann die Volumenänderung im Ausgangszustand durch Breathing (Fig. 2) als Referenz verwendet werden, um den Anteil des Swellings aufgrund von Alterungsvorgängen genauer zu ermitteln.

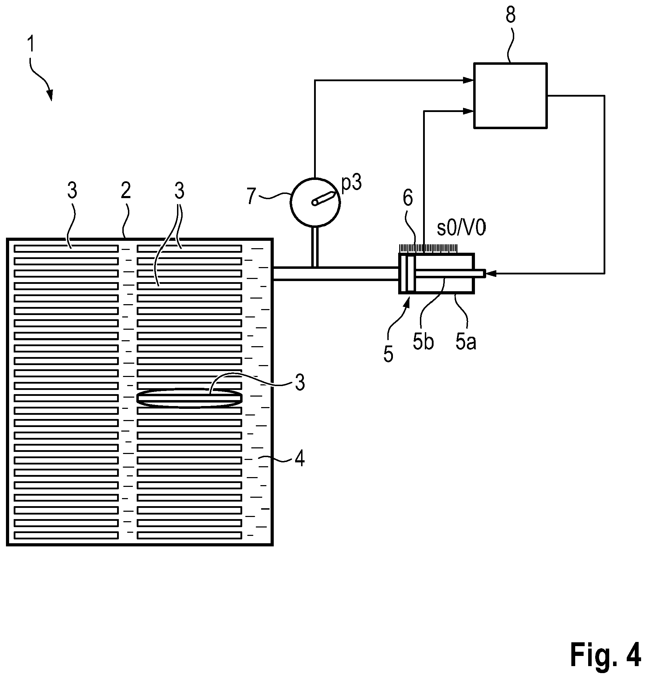

Die Druckmesseinrichtung 7 des hydrostatischen Verspannsystems kann weiterhin zur Früherkennung eines Thermal Runaway (Thermisches Durchgehen) einer Batteriezelle 3 eingesetzt werden, um die Detektion sicherheitskritischer Zustände zu verbessern. Im Fall eines Thermal Runaway tritt eine unerwünschte und unkontrollierte chemische Kettenreaktion in einer Batteriezelle 3 auf, welche mit einer starken Gasbildung einhergeht. Dies ist, wie in Fig. 4 veranschaulicht, mit einer starken Volumenzunahme der betreffenden Batteriezelle 3 verbunden. Bei konstanten gehaltenem Systemvolumen V0 steigt hierdurch der Druck p3 im flüssigen Medium 4 plötzlich stark an, wie dies in Fig. 6 dargestellt ist. Dies kann mittels der Druckmesseinrichtung 7 detektiert werden. Aus einer zeitlich schnell erfolgenden Druckerhöhung, d.h. einen hohen Gradienten des Drucks p, kann auf einen Thermal Runaway geschlossen werden und zwar zumeist deutlich früher, als eine Temperaturerhöhung im flüssigen Medium 4 gemessen wird.

Falls sich ein Thermal Runaway einer Batteriezelle 3 nicht verhindern lässt, reißt das Zellengehäuse der Batteriezelle 3, so dass heiße Gase aus der exothermen Kettenreaktion in das flüssige Medium 4 gelangen. Ein solches Bersten der Batteriezelle 3 wird durch ein charakteristisches Drucksignal in der Druckmesseinrichtung 7 des Verspannsystems detektiert. Weiterhin kann der Thermal Runaway einer einzelnen Batteriezelle 3 durch eine Zellüberwachung, beispielsweise anhand ihrer Zellspannung erkannt werden. Benachbarte Batteriezellen 3 werden durch die lokal hohe Energiefreisetzung und Temperaturerhöhung ebenfalls aufgeheizt, so dass auch an diesen ein Thermal Runaway auftreten kann, d.h. eine thermische Propagation droht.

Bei Nutzung der Druckmesseinrichtung 7 für das Verspannen des hydrostatischen Systems ist bereits in einer frühen Phase des Thermal Runaway meist noch vor einem Öffnen der Batteriezelle 3 ein Druckanstieg im hydrostatischen System zu beobachten, welcher deutlich schneller abläuft als beim Breathing oder Swelling. Über eine entsprechende Kategorisierung der Druckgradienten p kann dadurch ein Thermal Runaway sehr verlässlich detektiert werden.

Ein großer Vorteil ist auch die sehr frühzeitige Detektion eines Thermal Runaway in einer örtlich beliebigen Batteriezelle 3 im hydrostatischen System. Im Vergleich hierzu würde ein Thermal Runaway mittels herkömmlicher Temperaturmessung aufgrund der thermischen Trägheiten und der im ungünstigsten Fall großen räumliche Entfernung der durchgehenden Batteriezelle 3 von einer Temperaturmessstelle deutlich später detektiert werden.

Eine Detektion eines Thermal Runaway durch Gassensoren außerhalb der Batteriezellen 3 im System ist normalerweise erst möglich, wenn eine Batteriezelle 3 aufgrund ihres erhöhten Innendrucks öffnet. Auch die Bestimmung des Thermal Runaway durch Sensorik für Temperatur und Spannung kann möglicherweise erst verspätet oder nicht eindeutig erfolgen.

Durch Nutzung der Druckmesseinrichtung 7 der hydrostatischen Verspanneinrichtung ist hingegen bereits in einer frühen Phase des Thermal Runaway vor dem Öffnen der Batteriezelle 3 ein Druckanstieg im hydrostatischen System zu beobachten. Die Detektion ist dadurch deutlich schneller.

Algorithmen zur Früherkennung eines Thermal Runaway können beispielsweise in der Steuereinrichtung 8 abgelegt sein, in welcher dementsprechend Signale der Druckmesseinrichtung 7 ausgewertet werden. Bei Feststellen des Überschreitens eines Schwellwerts ṗ* für den Gradienten p des Drucks p des flüssigen Mediums wird ein Warnsignal generiert.

Durch die vorstehend erläuterte Erfindung wird ein zumeist ohnehin vorhandenes hydrostatisches Verspannsystem eines Batteriemoduls 1 eingesetzt, um den Alterungs- und Sicherheitszustand der Batteriezellen 3 desselben möglichst genau und zuverlässig zu bestimmen, so dass jeweils geeignet Gegenmaßnahmen rechtzeitig getroffen werden können.

Für die gleichzeitige Messung aller Batteriezellen 3 ist lediglich eine Druckmesseinrichtung 7 erforderlich, welche im Rahmen einer Druckregelung eines hydrostatischen Verspannsystems zumeist ohnehin vorhanden ist.

Die genaue Kenntnis des Alterungszustands (SoH) der Batteriezellen 3 ermöglicht eine effizientere Regelung eines optimalen Verspanndrucks.

Ferner ergibt sich eine Erhöhung der Batteriesicherheit durch das Erkennen beschleunigter Alterungseffekte oder das Erkennen des Fehlerverhaltens einzelner Batteriezellen 3.

In Verbindung mit bestehenden Batteriemanagementsystem wie beispielsweise in DE 10 2018 123 682 A2 beschrieben wird eine Möglichkeit für Redundanz sowie höhere Genauigkeit und Zuverlässigkeit geschaffen.

Das Batteriemodul 1 bietet ferner eine schnelle und zuverlässige Detektion eines Thermal Runaway einer oder mehrerer Batteriezellen 3.

Überdies wird im Rahmen eines Batteriemanagementsystems Redundanz bei der Detektion des Thermal Runaway einer Batteriezelle 3 ermöglicht. Eine solche Detektion kann einerseits erfolgen durch eine Ermittlung über Elektronik (Zellüberwachung, z.B. Spannungssignal, Temperatur) sowie nunmehr zusätzlich durch Erfassen eines charakteristisches Drucksignals im hydrostatischen Verspannsystem beim Aufblähen und/oder Öffnen der kritischen Batteriezelle 3.

Insbesondere kann das Öffnen oder Bersten einer Batteriezelle 3 während des Aufblähens der Batteriezelle 3 mithilfe der vorhandenen Druckmessung im hydrostatischen Verspannsystem über eine gewisse Zeit vorhergesagt werden, wodurch ein frühzeitiges Gegensteuern möglich wird, beispielsweise durch eine zeitigere Warnung der Insassen und/oder eine Erhöhung der Rettungszeit.

Die Erfindung wurde vorstehend anhand verschiedener Ausführungsbeispiele und -varianten näher erläutert. Diese dienen dazu, die Ausführbarkeit der Erfindung zu belegen. Technische Einzelmerkmale, welche oben im Kontext weiterer Einzelmerkmale erläutert wurden, können auch unabhängig von diesen sowie in Kombination mit weiteren Einzelmerkmalen verwirklicht werden, selbst wenn dies nicht ausdrücklich beschrieben ist, solange dies technisch möglich ist. Die Erfindung ist daher ausdrücklich nicht auf die konkret beschriebenen Ausführungsbeispiele, -varianten und Abwandlungen beschränkt, sondern umfasst alle durch die Patentansprüche definierten Ausgestaltungen.

### Bezugszeichenliste

- 1: Batteriemodul
- 2: Gehäuse
- 3: Batteriezelle
- 4: flüssiges Medium
- 5: Druckerzeugungsvorrichtung
- 5a: Druckzylinder
- 5b: Druckkolben
- 6: Messeinrichtung zur Erfassung der Kolbenstellung
- 7: Druckmesseinrichtung
- 8: Steuereinrichtung
- A, B, C: Kennlinien
- pi: Verspanndruck
- p: Druckgradient
- ṗ*: Schwellwert für Druckgradient
- p2,gas: Reaktion auf Druckpuls (Gas ist bereits entstanden)
- p2,solid: Reaktion auf Druckpuls (noch kein Gas entstanden)
- si: Kolbenweg
- Δs: Weg beim Druckpuls
- Vi: Volumen des hydrostatischen Systems

## Patentansprüche

1. Batteriemodul (1), umfassend
ein Gehäuse (2),
eine Vielzahl von Batteriezellen (3), die in dem Gehäuse (2) angeordnet sind,
ein flüssiges Medium (4), das in dem Gehäuse (2) die Batteriezellen (3) umgebend angeordnet ist, um die Batteriezellen (3) innerhalb des Gehäuses (2) mit einem hydrostatischen Druck zu beaufschlagen,
eine Druckerzeugungsvorrichtung (5) zur Einstellung des Drucks des flüssigen Mediums (4),
**gekennzeichnet durch**
eine Steuereinrichtung (8) zur Ansteuerung der Druckerzeugungsvorrichtung, welche derart konfiguriert ist, um eine Prüfroutine zur Alterungsbestimmung durchzuführen, bei welcher mittels der Druckerzeugungsvorrichtung (5) ein Druckpuls erzeugt und die hieraus resultierende Druck- und Volumenänderung des hydrostatischen Systems aus Batteriezellen (3) und flüssigem Medium (4) zu einer Referenzkennlinie in Beziehung gesetzt werden.

2. Batteriemodul (1) nach Anspruch 1, **dadurch gekennzeichnet, dass** die Druckerzeugungsvorrichtung (5) einen Druckkolben (5b) umfasst und dass eine Messeinrichtung (6) zur Erfassung der Stellung des Druckkolbens (5b) vorgesehen ist, deren Signal zur Bestimmung der Volumenänderung herangezogen wird.

3. Batteriemodul (1) nach Anspruch 1 oder 2, **dadurch gekennzeichnet, dass** die Referenzkennline die Abhängigkeit des Drucks von einer das Volumen des hydrostatischen Systems repräsentierenden Größe im ungealterten Zustand des Batteriemoduls (1) abbildet.

4. Batteriemodul (1) nach einem der Ansprüche 1 bis 3, **dadurch gekennzeichnet, dass** aus der Differenz des Druckanstiegs für eine vorgegebene Volumenänderung durch den Druckpuls im Vergleich zur Referenzkennlinie auf den Alterungszustand des Batteriemoduls (1) geschlossen wird.

5. Batteriemodul (1) nach einem der Ansprüche 1 bis 4, **dadurch gekennzeichnet, dass** aus der resultierenden Druck- und Volumenänderung infolge des Druckpulses auf das Ausmaß eines kompressiblen Gasvolumens in den Batteriezellen (3) geschlossen wird.

6. Batteriemodul (1) nach Anspruch 5, **dadurch gekennzeichnet, dass** eine Volumenänderung zwischen geladenem und entladenem Zustand des Batteriemoduls (1) im ungealterten Zustand als Referenz bei der Bestimmung des Ausmaßes des kompressiblen Gasvolumens in den Batteriezellen (1) verwendet wird.

7. Batteriemodul (1) nach einem der Ansprüche 1 bis 6, **dadurch gekennzeichnet, dass** eine Druckmesseinrichtung (7) zur Erfassung des Drucks des flüssigen Mediums (4) vorgesehen ist, deren Signal zur Bestimmung der Druckänderung herangezogen wird.

8. Batteriemodul (1), umfassend
ein Gehäuse (2),
eine Vielzahl von Batteriezellen (3), die in dem Gehäuse (2) angeordnet sind,
ein flüssiges Medium (4), das in dem Gehäuse (2) die Batteriezellen (3) umgebend angeordnet ist, um die Batteriezellen (3) innerhalb des Gehäuses (2) mit einem hydrostatischen Druck zu beaufschlagen, und
eine Druckmesseinrichtung (7) zur Erfassung des Drucks des flüssigen Mediums (4), **gekennzeichnet durch**
eine Steuereinrichtung (8), welche mit der Druckmesseinrichtung (7) zusammenwirkt und derart konfiguriert ist, um bei Feststellen des Überschreitens eines Schwellwerts (ṗ*) für den Gradienten des Drucks des flüssigen Mediums (4) ein Warnsignal zu generieren.

9. Batteriemodul (1) nach Anspruch 8, welches nach einem der Ansprüche 1 bis 6 weitergebildet ist.

10. Batteriemodul (1) nach einem der Ansprüche 1 bis 9, **dadurch gekennzeichnet, dass** dieses ein Traktionsbatteriemodul für ein Fahrzeug ist.
